(19) Europäisches Patentamt
European Patent Office
Office européen des brevets

(11) **EP 0 901 019 B1**

(12) **EUROPÄISCHE PATENTSCHRIFT**

(45) Veröffentlichungstag und Bekanntmachung des Hinweises auf die Patenterteilung:
**03.06.2009   Patentblatt 2009/23**

(51) Int Cl.:
***G01R 21/133*** *(2006.01)*

(21) Anmeldenummer: **98114611.1**

(22) Anmeldetag: **04.08.1998**

(54) **Elektrizitätszähler zur Messung elektrischer physikalischer Grössen, die Parameter oder Funktionen sind von im Elektrizitätszähler gemessenen Spannungen und/oder Strömen**

Electricity meter for measuring physical variables, which are parameters or functions of the voltages and/or currents measured by the electricity meter

Compteur d'électricité pour mesurer des variables physiques, qui sont des paramètres ou des fonctions de tensions et/ou courants mesurés par le compteur

(84) Benannte Vertragsstaaten:
**CH DE FI FR GB LI SE**
Benannte Erstreckungsstaaten:
**SI**

(30) Priorität: **25.08.1997   US 927386**

(43) Veröffentlichungstag der Anmeldung:
**10.03.1999   Patentblatt 1999/10**

(73) Patentinhaber: **Landis+Gyr AG**
**6300 Zug (CH)**

(72) Erfinder:
• **Adame, Javier**
**6318 Walchwil (CH)**

• **Junker, John**
**Lafayette, IN 47905 (US)**
• **Burns, Gordon**
**West Lafayette, IN 47906 (US)**
• **Voisine, John Thomas**
**Lafayette, IN 47905 (US)**

(74) Vertreter: **Lagler, Louis**
**Rentsch & Partner**
**Postfach 2441**
**8022 Zürich (CH)**

(56) Entgegenhaltungen:
WO-A-94/03818          US-A- 4 473 810
US-A- 4 672 555        US-A- 4 884 021
US-A- 5 298 857        US-A- 5 298 859
US-A- 5 301 121        US-A- 5 742 512

**Beschreibung**

Die Erfindung bezieht sich auf Elektrizitätszähler zur Messung elektrischer physikalischer Grössen, die Parameter oder Punktionen sind von im Elektrizitütszähler gemessenen Spannungen und/oder Ströme, gcmäss dem Oberbegriff des Anspruchs 1.

Elektrizitätszähler sind oft universelle Elektrizitätszähler, die ausser einer Wirkenergie noch andere Energiearten (Kombinationszähler) und/oder noch andere physikalische elektrische Grössen messen, wie z. B. Frequenzen, Phasen, Phasendifferenzen, Leistungsfaktoren, usw., die im Zusammenhang mit elektrischen Leistungs- und/oder Energiemessungen sinnvoll sind. Die Vielfalt und Art der zu ermittelnden Grössen kann dabei je nach Produkt- und/oder Länderanforderungen sehr unterschiedlich sein und ist in gewissen Fällen oft im voraus nicht bekannt oder muss sogar im nachhinein im Laufe der Zeit geändert werden. Auch ist es möglich, dass ursprünglich reine Wirkenergie-Zähler später in Kombinationszähler oder universelle Elektrizitätszähler umgewandelt werden müssen.

Elektrizitätszähler der eingangs genannten Art sind aus der US 4 884 021, US 5 212 441, US 5 298 854, US 5 298 856 und US 5 298 859 bekannt, in denen in einem ersten Prozessor Werte einer oder mehrerer Leistungsarten ermittelt und diese in einem nachgeschalteten zweiten Prozessor in Werte dazugehöriger Energiearten umgerechnet werden.

US 4 884 021 und US 4 672 555 offenbaren einen Elektrizitätszahler, bzw. eine Strom-/Spannungsüberwachungseinheit, bei denen jeweils die erfassten Strom- und Spannungswerte digitalisiert werden und anschliessend zwecks Berechnung weiterer physikaliser Grössen genutzt werden.

In der US 5 298 859 wird ein Elektrizitätszähler zur Messung elektrischer physikalischer Grössen gezeigt die Parameter oder Funktionen sind von im Elektrizitätszähler gemessenen Spannungen und/oder Strömen, umfassend einen ersten Prozessor, einen nachgeschalteten zweiten Prozessor und Analog/Digital-Wandler zur Wandlung analoger Abtastwerte der Spannungen und/oder Ströme in vorübergehend anstehende Digitalwerte, wobei der erste Prozessor zur Weiterverarbeitung der Digitalwerte dient, wobei der erste Prozessor ein so schneller Prozessor ist, dass er fähig ist, ohne vorhergehende Zwischenspeicherung der Digitalwerte, von den letzteren während deren vorübergehenden Anstchens Werte von Hilfsgrössen abzuleiten, deren Ermittlung rechenauf wendig ist, ihre abgespeicherten Werte jedoch im zweiten Prozessor erforderlich sind zu einer dortigen rechenarmen Ermittlung von Werten der zu messenden elektrischen physikalischen Grössen.

Es ist auch aus weiteren Druckschriften bekannt, z. B. aus US 4 794 369, US 5 122 735, WO 93/17345. WO 93/17390, EP 742 442 A, EP 742 443 A und EP 742 444, dass in einem ersten Prozessor Werte einer oder mehrerer Energiearten ermittelt werden und diese ats Digitalwerte oder in Gestalt einer Frequenz einer Impulsfolge, die proportional einer zur Energie gehörenden Leistung ist, an einen zweiten Prozessor weitergeleitet werden, wo z. B. die Energiewerte je nach Tarif preislich unterschiedlich gewichte werden, ggf. nach einer vorhergehenden Zahnung der Impulse der Impulsfolge.

Im angegebenen Stand der Technik werden im ersten Prozessor jeweils Endgültigwerte physikalischer Grössen, nämlich einer oder mehrerer elektrischen Leistungs- und/oder Energicarten ermittelt. Die Erzeugung solcher Endgültigwerten am Ausgang des ersten Prozessors beinhaltet eine grosse Wahrscheinlichkeit, dass - bei späteren Änderungen und/oder Erweiterungen der Elektrizitätszähler - je nach Produkt- und/oder Länderanforderungen einige im ersten Prozessor durchgeführten Berechnungen im nachgeschalteten zweiten Prozessor erneut durchgeführt oder rückgängig gemacht werden müssen, um Endgültigwerte weiterer, noch nicht im Elektrizitätszähler vorhandener physikalischer Grössen, z. B. anderer Energiearten, zu ermitteln. Dies führt dann im geänderten bzw. erweiterten Elektrizitätszähler zu Leerlauf unnötigem Rechenaufwand sowie Schnelligkeits- und Zeitverlusten im zweiten, wenn nicht sogar in beiden Prozessoren und bedingt dort möglicherweise sogar noch einen zusätzlichen Speicheraufwand.

Der Erfindung liegt die Aufgabe zugrunde, ein Elektrizitätszähler der eingangs genannten Art zu verwirklichen, der - bei späteren Änderungen und/oder Erweiterungen des Elektrizitätszählers - mindestens in einem der beiden Prozessoren Leerlauf, unnötigen Rechenaufwand, zusätzlichen Speicheraufwand sowie Schnelligkeits- und Zeitverluste vermeidet und der zur Ermittlung von Endgültigwerten zusätzlicher physikalischer Grössen, die bisher im Elektrizitätszähler noch nicht ermittelt wurden, ohne weiteres auf einfache Weise geändert und/oder erweitert werden kann, ohne dass Hardware- und/oder Software-Änderungen im ersten Prozessor erforderlich sind.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

Ein Ausführungsbeispiel der Erfindung ist in der Zeichnung dargestellt und wird im folgenden näher beschrieben.

Es zeigen:

Fig. 1    ein Schaltbild eines Elektrizitätszählers,

Fig. 2    ein Schaltbild eines bevorzugt verwendeten Analog/Digital-Wandlers und

Fig. 3    einen Aufbau eines bevorzugt verwendeten Stromsensors.

Die erfindungsgemässen Elektrizitätszähler dienen zur Messung elektrischer physikalischer Grössen, die Parameter - z. B. Frequenzen f und Phasen $\varphi$ -

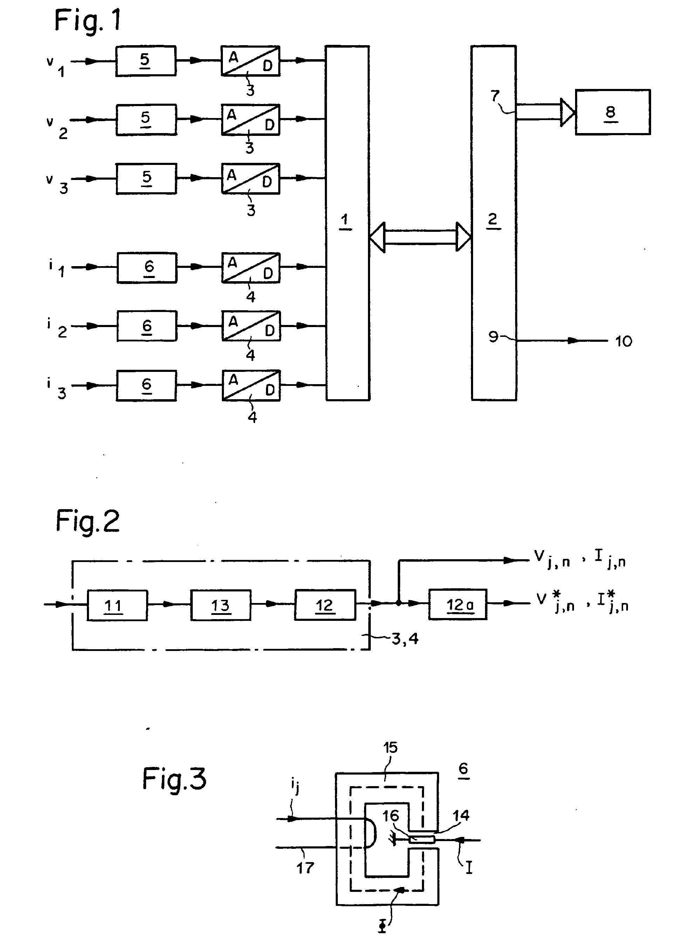

oder Funktionen von in den Elektrizitätszählern gemessenen Spannungen $v_j$ und/oder Srömen $i_j$ sind. Diese Elektrizitätszähler sind jeweils mit einem ersten Prozessor 1, einem nachgeschalteten zweiten Prozessor 2 und Analog/Digital-Wandlern 3 und 4 versehen. In Dreiphasen-Elektrizitätszähler sind die gemessenen Spannungen $v_j$ und Sröme $i_j$ vorzugsweise Netz-Phasenspannungen bzw. Netz-Phasenströmen, mit j = 1, 2 und 3. Die Analog/Digital-Wandler 3 und 4 dienen zur Wandlung analoger Momentanwerte, vorzugsweise Abtastwerte, der Spannungen $v_j$ und/oder Ströme $i_j$ in vorübergehend, relativ kurzzeitig anstehenden Digitalwerten $V_{j,n}$ und $I_{j,n}$, wobei n eine fortlaufende Nummer der Abtastwerte ist und alle ganzzahligen Werte von 1 bis N annehmen kann. Die ganze Zahl N bezeichnet eine Anzahl Abtastwerte, die pro gewählter Akkumulationszeit gemessen werden. In der Fig. 1 ist ein Dreiphasen-Elektrizitätszähler dargestellt, dessen erster Prozessor 1 über eine Busverbindung mit dem nachgeschalteten zweiten Prozessor 2 verbunden ist. Die drei Spannungen $v_j$, mit j = 1, 2 und 3, werden mittels je eines Spannungssensors 5 gemessen, dessen Ausgang über je einen von drei Analog/Digital-Wandlern 3 mit einem getrennten Eingang des Prozessors 1 verbunden ist. Zu jeder Spannung $v_j$ gehört ein Strom $i_j$. Die drei Ströme $i_j$, mit j = 1, 2 und 3, werden mittels je eines Stromsensors 6 gemessen, dessen Ausgang über je einen von drei Analog/Digital-Wandlern 4 mit einem weiteren getrennten Eingang des Prozessors 1 verbunden ist. Statt total sechs getrennte Analog/Digital-Wandler 3 und 4 bzw. sechs getrennte Eingänge des Prozessors 1 können auch weniger Analog/Digital-Wandler bzw. weniger Eingänge verwendet werden unter der Bedingung, dass dem betreffenden Analog/Digital-Wandler bzw. Eingang ein Multiplexer vorgeschaltet ist, dessen Eingänge mit den Ausgängen mehrerer Sensoren 3 oder 4 bzw. mehrerer Analog/Digital-Wandler 3 oder 4 verbunden sind. Z. B. können die Ausgänge der drei Sensoren 5 bzw. 6 über je einen Multiplexer mit einem Eingang eines einzigen Analog/Digital-Wandlers 3 bzw. 4 verbunden sein. Ein Busausgang 7 des Prozessors 2 ist auf eine Anzeige ("display") 8 geführt zur Anzeige der zu messenden elektrischen physikalischen Grössen. Die digitalen Werte der letzteren können auch zwecks einer Fernablesung zeitseriell über einen weiteren Ausgang 9 des Prozessors 2 auf einen Ausgang 10 des Elektrizitätszählers geführt sein.

Der erste Prozessor 1 dient zur Weiterverarbeitung der in den Analog/Digital-Wandlern 3 und 4 erzeugten Digitalwerte $V_{j,n}$ und $I_{j,n}$, mit n = 1 bis N. Dabei wird der Wert von N so gewählt, dass einerseits der zweite Prozessor 2 entlastet wird und nur eine reduzierte Rechenleistung benötigt, sowie andererseits die Ausgangswerte des ersten Prozessors 1 genügend oft am Eingang des zweiten Prozessors 2 erscheinen, dass sie für diesen in seinen Applikationen immer noch quasi Momentanwerte darstellen. Der zeitliche Abstand zwischen zwei aufeinanderfolgenden Eigangswerten des zweiten Prozessors 2 ist vorzugsweise ¼ Sekunde bis 1 Sekunde.

Der erste Prozessor 1 ist ein so schneller Prozessor, dass er fähig ist, ohne vorhergehende Zwischenspeicherung der Digitalwerte $V_{j,n}$ und $I_{j,n}$, von den letzteren während deren vorübergehendes, relativ kurzzeitiges Anstehen Werte von Hilfsgrössen abzuleiten, deren Ermittlung rechenaufwendig ist, wobei die Hilfsgrössen keine unmittelbare physikalische Bedeutung besitzen, ihre abgespeicherte Werte jedoch im zweiten Prozessor 2 erforderlich sind zu einer dortigen geruhsamen und rechenarmen Ermittlung von massenhaft benötigten Werten der zu messenden elektrischen physikalischen Grössen. Der erste Prozessor 1 ist vorzugsweise so schnell, dass seine Verarbeitungszeit einer 8Bit x 8Bit-Multiplikation kleiner oder gleich 50 Nanosekunden ist. Er ist bevorzugt ein sogenannter DSP-Prozessor ("digital signal processor"), der relativ teuer ist und eine relativ beschränkte Speicherkapazität besitzt. Der zweite Prozessor 2 ist dagegen vorzugsweise ein zu einer Massenverarbeitung von Daten geeigneter, relativ langsamer Prozessor, dessen Verarbeitungszeit einer 8Bit x 8Bit-Multiplikation in der Grössenordnung von 5 Mikrosekunden liegt.

Die Werte der zu messenden elektrischen physikalischen Grössen sind in Mehrphasen-Elektrizitätszählern, da wo sinnvoll, vorzugsweise Werte pro Phase und/oder Gesamtwerte aller Phasen zusammen.

Eine oder mehrere der zu messenden elektrischen physikalischen Grössen sind vorzugsweise:

- eine oder mehrere Sorten elektrischer Energie und/oder elektrischer Leistung, wie z. B. Wirkenergie, Blindenergie, Scheinenergie, Wirkleistung, Blindleistung und/oder Scheinleistung, und/oder
- ein oder mehrere Phasenwinkel, die jeweils zwischen einer der Spannungen $v_j$ und einem ihr zugehörigen Strom $i_j$ vorhanden sind, und/oder
- ein oder mehrere Phasenwinkel, die jeweils zwischen zwei der Spannungen $v_j$ oder zwei der Ströme $i_j$ vorhanden sind, und/oder
- Leistungsfaktoren $\lambda$ und/oder
- die Spannungen $v_j$ und/oder Ströme $i_j$, wenn deren Effektivwerte im Prozessor 2 zu ermitteln sind, wobei dann die Werte eines oder mehrerer der zu messenden elektrischen physikalischen Grössen Effektivwerte der Spannungen $v_j$ und/oder der Ströme $i_j$ sind, und/oder
- Frequenzen der Spannungen $v_j$ und/oder der Ströme $i_j$ und/oder
- in Mehrphasen-Elektrizitätszählern ein Null-Leiter-Strom und/oder eine Null-Leiter-Spannung.

Die im ersten Prozessor 1 berechneten Hilfsgrössen sind, mit j= 1, 2 und 3, vorzugsweise die akkumulierten Werte $\sum\limits_{n=1}^{N} \langle V_{j,n} . I_{j,n} \rangle$ und/oder

$$\sum_{n=1}^{N} \langle V^{\bullet}_{j,n} . I_{j,n} \rangle \text{ und/oder } \sum_{n=1}^{N} \langle V_{j,n} . I^{\bullet}_{j,n} \rangle \text{ und/oder}$$

$$\sum_{n=1}^{N} \langle V^{2}_{j,n} \rangle \text{ und/oder } \sum_{n=1}^{N} \langle I^{2}_{j,n} \rangle \text{ und/oder}$$

$$\sum_{n=1}^{N} \langle \sum_{j=1}^{3} I_{j,n} \rangle^{2} \text{ , wobei der letztere Wert nur in Dreipha-}$$

sen-Elektrizitätszählern sinnvoll ist.

Die Bezeichnungen $V^{*}_{j,n}$ und $I^{*}_{j,n}$ stellen bevorzugt Digitalwerte am Ausgang eines als 90°-Phasenschieber wirkenden Digitalfilters 12a (siehe Fig. 2) dar, welches an seinem Eingang mit den Abtastwerten der Spannungen $v_j$ bzw. der Ströme $i_j$ gespeist ist, wobei klar ist, dass die 90°-Phasenverschiebung auch auf andere Weise realisiert werden kann. Die zugehörigen Summenwerten $\sum_{n=1}^{N} \langle V^{\bullet}_{j,n} . I_{j,n} \rangle$ oder $\sum_{n=1}^{N} \langle V_{j,n} . I^{\bullet}_{j,n} \rangle$ dienen z. B. zur Ermittlung der Blindenergie und/oder Blindleistung im Prozessor 2. Der Summenwert $\sum_{j=1}^{3} I_{j,n}$ ist in einer Dreiphasenanordnung mit Null-Leiter die Summe eines Abstastwertes der drei Netz-Phasenströme $i_j$ und stellt einen Abtastwert des Null-Leiter-Stromes dar.

Im erfindungsgemässen Elektrizitätszähler genügt - bei einer späteren Änderung oder Erweiterung desselben - eine Umprogrammierung des Prozessors 2, um Werte einer jeden, in einem Elektrizitätszähler sinnvollen physikalischen Grösse zu ermitteln, da alle zur Ermittlung dieser Grösse erforderlichen Hilfsgrössen bereits im Prozessor 1 ermittelt und gespeichert werden, um dann an den Prozessor 2 weitergeliefert und dort, ohne Rückgängigmachung von Rechnungen, weiterverwendet zu werden.

Die Analog/Digital-Wandler 3 und 4 bestehen vorzugsweise je aus einem Sigma-Delta-Modulator 11 und einem nachgeschalteten Dezimationsfilter 12, wobei zwischen den beiden letzteren bevorzugt ein digitalgesteuertes Schieberegister 13 zwischengeschaltet ist (siehe Fig. 2) zur Kompensation von Zeitverschiebungen, die bei der Ermittlung der Ströme $i_j$ möglicherweise erzeugt werden.

Pro gemessener Strom $i_j$ ist zur Messung des betreffenden Stromes $i_j$ jeweils ein Stromsensor 6 vorhanden, vorzugsweise ein Stromwandler, eine Rogowski-Spule mit nachgeschaltetem Integrator oder ein Hallelememt 16 (siehe Fig. 3). Das Letztere ist in einem Luftspalt 14 eines Magnetkreises 15 angeordnet und mit einem konstanten Strom I gespeist. Es misst den Strom $i_j$ mittels eines vom letzteren in den Magnetkreis 15 erzeugten proportionalen Magnetflusses $\Phi$. Der Strom $i_j$ fliesst dabei durch einen Leiter 17, der einen Schenkel des Magnetkreises 15 z. B. U-förmig umgibt. Die bekannte Rogowski-Spule, im englischen Sprachgebiet auch "embedded coil" genannt, siehe US-PS 5,298,857 oder US-PS 4,810,989, ermittelt dagegen $di_j/dt$, welcher Wert dann jeweils im nachgeschalteten Integrator in $i_j$ umgewandelt wird.

## Patentansprüche

1. Elektrizitätszähler zur Messung elektrischer physikalischer Grössen, die Parameter (f, $\varphi$) oder Funktionen, insbesondere Energien, Leistungen, Leistungsfaktoren, sind von im Elektrizitätszähler gemessenen Spannungen ($v_j$) und/oder Ströme ($i_j$), mit einem ersten Prozessor (1), einem nachgeschalteten zweiten Prozessor (2) und Analog/Digital-Wandlem (3, 4) zur Wandlung analoger Abtastwerte der Spannungen ($v_j$) und/oder Ströme ($i_j$) in vorübergehend anstehende Digitalwerten ($V_{j,n}$, $I_{j,n}$), wobei der erste Prozessor (1) zur Weiterverarbeitung der Digitalwerte ($V_{j,n}$, $I_{j,n}$) dient, wobei der erste Prozessor (1) ein so schneller Prozessor ist, dass er fähig ist, ohne vorhergehende Zwischenspeicherung der Digitalwerte ($V_{j,n}$, $I_{j,n}$), von den letzteren während deren vorübergehenden Anstehens Werte von Hilfsgrössen abzuleiten, deren Ermittlung rechenaufwendig ist, ihre abgespeicherten Werte im zweiten Prozessor (2) erforderlich sind zu einer dortigen rechenarmen Ermittlung von Werten der zu messenden elektrischen physikalischen Grössen, **dadurch gekennceichnet, dass** die Hilfsgrössen akkumulierte Werte $\sum_{n=1}^{N} \langle V^{\bullet}_{j,n} . I_{j,n} \rangle$ und/oder

$$\sum_{n=1}^{N} \langle V_{j,n} . I^{\bullet}_{jn} \rangle \text{ sind, mit n = 1 bis N, wobei } V_{j,n} \text{ und}$$

$I_{j,n}$ die Digitalwerte der Abtastwerte der Spannungen ($v_j$) beziehungsweise der Ströme ($i_j$) sind, $V^{*}_{j,n}$ und $I^{*}_{j,n}$ Digitalwerte am Ausgang eines als 90°-Phasenschieber wirkende Digitalfilters sind, welches an seinem Eingang mit den Abtastwerten der Spannungen $v_j$ beziehungsweise der Ströme $i_j$ gespeist ist, und N eine ganze Zahl ist, die eine Anzahl Abtastwerte bezeichnet, die pro gewählter Akkumulationszeit gemessen werden.

2. Elektrizitätszähler nach Anspruch 1, **dadurch gekennzeichnet, dass** der erste Prozessor (1) so schnell ist, dass seine Verarbeitungszeit einer 8Bit x 8Bit-Multiplikation kleiner oder gleich 50 Nanosekunden ist.

3. Elektrizitätszähler nach Anspruch 1 oder 2, **dadurch gekennzeichnet, dass** der zweite Prozessor (2) ein zu einer Massenvcrarbeitung von Daten geeigneter, relativ langsamer Prozessor ist, dessen Verarbeitungszeit einer 8Bit x 8Bit-Multiplikation in der Grössenordnung von 5 Mikrosekunden liegt.

4.  Elektrizitätszähler nach einem der Ansprüche 1 bis 3, **dadurch gekennzeichnet, dass** pro gemessener Strom ($i_j$) jeweils ein in einem Luftspalt (14) eines Magnetkreises (15) angeordnetes und mit einer konstanten Spannung (V) gespeistes Hallelement (16) vorhanden ist zur Messung des betreffenden Stromes ($i_j$) mittels eines vom letzteren in den Magnetkreis (15) erzeugten proportionalen Magnetflusses ($\Phi$).

5.  Elektrizitätszähler nach einem der Ansprüche 1 bis 3, **dadurch gekennzeichnet, dass** pro gemessener Strom ($i_j$) jeweils ein Stromwandler vorhanden ist zur Messung des betreffenden Stromes ($i_j$).

6.  Elektrizitätszähler nach einem der Ansprüche 1 bis 3, **dadurch gekennzeichnet, dass** pro gemessener Strom ($i_j$) jeweils eine Rogowski-Spule mit nachgeschaltetem Integrator vorhanden ist zur Messung des betreffenden Stromes ($i_j$).

7.  Elektrizitätszähler nach einem der Ansprüche 1 bis 6, **dadurch gekennzeichnet, dass** die Analog/Digital-Wandler (3, 4) je aus einem Sigma-Delta-Modululor (11) und einem nachgeschalteten Dezimationsfilter (12) bestehen und dass zwischen den beiden letzteren ein digitalgesteuertes Schieberegister (13) zwischengeschaltet ist zur Kompensation von Zcitverschiebungen, die bei der Ermittlung der Ströme ($i_j$) erzeugt werden.

8.  Elektrizitätszähler nach einem der Ansprüche 1 bis 7, **dadurch gekennzeichnet, dass** eine oder mehrere der zu messenden elektrischen physikalischen Grössen eine oder mehrere Sorten elektrischer Energie und/oder elektrischer Leistung sind.

9.  Elektrizitätszähler nach einem der Ansprüche 1 bis 8, **dadurch gekennzeichnet, dass** eine oder mehrere der zu messenden elektrischen physikalischen Grössen ein oder mehrere Phasenwinkel sind, die jeweils zwischen einer der Spannungen ($v_j$) und dem zugehörigen Strom ($i_j$) vorhanden sind.

10. Elekltrizitätszähler nach einem der Ansprüche 1 bis 9, **dadurch gekennzeichnet, dass** eine oder mehrere der zu messenden elektrischen physikalischen Grössen ein oder mehrere Phasenwinkel sind, die jeweils zwischen zwei der Spannungen ($v_j$) oder zwei der Ströme ($i_j$) vorhanden sind.

11. Elektrizitätszähler nach einem der Ansprüche 1 bis 10, **dadurch gekennzeichnet, dass** eine oder mehrere der zu messenden elektrischen physikalischen

Grössen Leistungsfaktoren ($\lambda$) sind

12. Elektrizitätszähler nach einem der Ansprüche 1 bis 11, **dadurch gekennzeichnet, dass** eine oder mehrere der zu messenden elektrischen physikalischen Grössen Frequenzen der Spannungen ($v_j$) und/oder Ströme ($i_j$) sind.

13. Elektrizitätszähler nach einem der Ansprüche 1 bis 12, **dadurch gekennzeichnet, dass** in Mehrphasen-Elektrizitätszählern eine oder mehrere der zu messenden elektrischen physikalischen Grössen ein Null-Leiter-Strom und/oder eine Null-Leiter-Spannung ist.

14. Elektrizitätszähler nach einem der Ansprüche 1 bis 13, **dadurch gekennzeichnet, dass** Werte eines oder mehrerer der zu messenden elektrischen physikalischen Grössen Effektivwerte der Spannungen ($v_j$) und/oder der Ströme ($i_j$) sind.

15. Elektrizitätszähler nach einem der Ansprüche 1 bis 14, **dadurch gekennzeichnet, dass** die Hilfsgrössen akkumulierte Werte $\sum_{n=1}^{N} \langle V_{j,n} \cdot I_{j,n} \rangle$ und/oder

    $\sum_{n=1}^{N} \langle V_{j,n}^2 \rangle$ und/oder $\sum_{n=1}^{N} \langle I_{j,n}^2 \rangle$ sind, mit n = 1 bis N, wobei $v_{j,n}$ und $I_{j,n}$ die Digitalwerte der Abtastwerte der Spannungen ($v_j$) bezichungsweise der Ströme ($i_j$) sind und N eine ganze Zahl ist, die eine Anzahl Abtastwerte bezeichnet, die pro gewählter Akkumulationszeit gemessen werden.

16. Eleklrizitätszähler nach einem der Ansprüche 1 bis 15, **dadurch gekennzeichnet, dass** die Elektrizitätszähler Dreiphasen-Elektrizitätszähler und die Hilfsgrössen akkumulierte Werte $\sum_{n=1}^{N} \langle \sum_{j=1}^{3} I_{j,n} \rangle^2$

    sind, mit n = 1 bis N und j = 1 bis 3, wobei $I_{j,n}$ die Digitalwerte der Abtastwerte der Ströme ($i_j$) sind und N eine ganze Zahl ist, die eine Anzahl Abtastwerte bezeichnet, die pro gewählter Akkumulationszeit gemessen werden.

**Claims**

1.  Electricity meter for measurement of electrical physical variables which are parameters (f, $\varphi$) or functions, in particular energies, powers, power factors, of voltages ($v_j$) and/or currents ($i_j$) measured in the electricity meter, having a first processor (1) a downstream second processor (2) and analogue/digital converters (3, 4) for conversion of analogue sample values of the voltages ($v_j$) and/or currents ($i_j$) to digital values ($V_{j,n}$, $I_{j,n}$), which exist temporarily, with the first processor (1) being used for further processing of the digital values ($v_{j,n}$, $I_{j,n}$), with the first processor (1) being a processor which is sufficiently fast that it can derive values of auxiliary variables from the digital values ($V_{j,n}$, $I_{j,n}$) during their temporary existence without previously buffer-storing them, the determination of which auxiliary variables is computation intensive, and whose stored values are required in the second processor (2) for determination there, requiring little computation complexity, of values of the electrical physical variables to be measured, **characterized in that** the auxiliary variables are accumulated values $\sum\limits_{n=1}^{N} \left\langle V^*_{j,n}, I_{j,n} \right\rangle$ and/or

$\sum\limits_{n=1}^{N} \left\langle V_{j,n}, I^*_{j,n} \right\rangle$ , where n = 1 to N, where $V_{j,n}$ and $I_{j,n}$ are the digital values of the sample values of the voltages ($v_j$) and of the currents ($i_j$), $V^*_{j,n}$ and $I^*_{j,n}$ are digital values at the output of a digital filter which acts as a 90° phase shifter and is fed at its input with the sample values of the voltages $v_j$ and of the currents $i_j$, and where N is an integer which denotes a number of sample values which are measured in each selected accumulation time.

2.  Electricity meter according to Claim 1, **characterized in that** the first processor (1) is sufficiently fast that its processing time for an 8bit x 8bit multiplication is less than or equal to 50 nanoseconds.

3.  Electricity meter according to Claim 1 or 2, **characterized in that** the second processor (2) is a relatively slow processor, which is suitable for bulk processing of data and whose processing time for an 8bit x 8bit multiplication is in the order of magnitude of 5 microseconds.

4.  Electricity meter according to one of Claims 1 to 3, **characterized in that** a Hall element (16), which is arranged in an air gap (14) of a magnetic circuit (15) and is fed with a constant voltage (V) is provided for each measured current ($i_j$), in order to measure the relevant current ($i_j$) by means of a proportional magnetic flux ($\Phi$) which is produced by the latter in the magnetic circuit (15).

5.  Electricity meter according to one of Claims 1 to 3, **characterized in that** a current transformer is provided for each measured current ($i_j$), in order to measure the relevant current ($i_j$).

6.  Electricity meter according to one of Claims 1 to 3, **characterized in that** a Rogowski coil with a downstream integrator is provided for each measured current ($i_j$), in order to measure the relevant current ($i_j$).

7.  Electricity meter according to one of Claims 1 to 6, **characterized in that** the analogue/digital converters (3, 4) each comprise a sigma-delta modulator (11) and a downstream decimation filter (12) and **in that** a digitally controlled shift register (13) is connected between the two latter in order to compensate for time shifts which are produced in the determination of the currents ($i_j$)

8.  Electricity meter according to one of Claims 1 to 7, **characterized in that** one or more of the electrical physical variables to be measured is or are one or more types of electrical energy and/or electrical power.

9.  Electricity meter according to one of Claims 1 to 8, **characterized in that** one or more of the electrical physical variables to be measured is or are one or more phase angles which are respectively present between one of the voltages ($v_j$) and the associated current ($i_j$).

10. Electricity meter according to one of Claims 1 to 9, **characterized in that** one or more of the electrical physical variables to be measured is or are one or more phase angles which are in each case present between two of the voltages ($v_j$) or two of the currents ($i_j$).

11. Electricity meter according to one of Claims 1 to 10, **characterized in that** one or more of the electrical physical variables to be measured is or are power factors (X).

12. Electricity meter according to one of Claims 1 to 11, **characterized in that** one or more of the electrical physical variables to be measured is or are frequencies of the voltages ($v_j$) and/or currents ($i_j$).

13. Electricity meter according to one of Claims 1 to 12, **characterized in that** one or more of the electrical physical variables to be measured in polyphase electricity meters is/are a neutral-conductor current and/or a neutral-conductor voltage.

14. Electricity meter according to one of Claims 1 to 13, **characterized in that** values of one or more of the electrical physical variables to be measured is or are root-mean-square values of the voltages ($v_j$) and/or of the currents ($i_j$).

15. Electricity meter according to one of Claims 1 to 14, **characterized in that** the auxiliary variables are accumulated values $\sum_{n=1}^{N} \langle V_{j,n}, I_{j,n} \rangle$ and/or

$\sum_{n=1}^{N} \langle V_{j,n}^2 \rangle$ and/or $\sum_{n=1}^{N} \langle I_{j,n}^2 \rangle$, where n = 1 to N, where $V_{j,n}$ and $I_{j,n}$ are the digital values of the sample values of the voltages ($v_j$) and of the currents ($i_j$) and N is an integer which denotes a number of sample values which are measured in each selected accumulation time.

16. Electricity meter according to one of Claims 1 to 15, **characterized in that** the electricity meters are three-phase electricity meters and the auxiliary variables are accumulated values $\sum_{n=1}^{N} \left\langle \sum_{j=1}^{3} I_{j,n} \right\rangle^2$,

where n=1 to N and j=1 to 3, where $I_{j,n}$ are the digital values of the sample values of the currents ($i_j$) and N is an integer which denotes a number of sample values which are measured in each selected accumulation time.

**Revendications**

1. Compteur d'électricité pour mesurer des grandeurs physiques électriques qui sont des paramètres (f, φ) ou des fonctions, en particulier des énergies, des puissances, des facteurs de puissance, etc.), de tensions ($v_j$) et/ou de courants ($i_j$) mesurés dans le compteur d'électricité avec un premier processeur (1), un deuxième processeur (2) monté en aval et des convertisseurs analogique/numérique (3, 4) pour convertir des échantillons analogiques des tensions ($v_j$) et/ou des courants ($i_j$) en valeurs numériques temporairement présentes ($V_{j,n}$, $I_{j,n}$), le premier processeur (1) servant à la transmission des valeurs numériques ($V_{j,n}$, $I_{j,n}$), le premier processeur (1) étant un processeur assez rapide pour être capable, sans stockage temporaire préalable des valeurs numériques ($V_{j,n}$, $I_{j,n}$), de dériver de ces dernières, pendant leur présence temporaire, des valeurs de grandeurs auxiliaires dont la détermination est gourmande en temps de calcul, leurs valeurs mémorisées étant nécessaires dans le deuxième processeur (2) pour une détermination dans celui-ci, peu gourmande en temps de calcul, de valeurs des grandeurs physiques électriques à mesurer, **caractérisé en ce que** les grandeurs auxiliaires sont des valeurs accumulées $\sum_{n=1}^{N} (V_{j,n}^* \cdot I_{j,n})$ et/ou $\sum_{n=1}^{N} (V_{j,n} \cdot I_{j,n}^*)$,

avec n = 1 à N, $V_{j,n}$ et $I_{j,n}$ étant respectivement les valeurs numériques des échantillons des tensions ($v_j$) et des courants ($i_j$), $V_{j,n}^*$ et $I_{j,n}^*$ des valeurs numériques à la sortie d'un filtre numérique fonctionnant en déphaseur à 90° qui est alimenté à son entrée par les échantillons des tensions $v_j$, respectivement des courants ($i_j$), et N étant un nombre entier qui désigne un nombre d'échantillons qui sont mesurés par temps d'accumulation choisi.

2. Compteur d'électricité selon la revendication 1, **caractérisé en ce que** le premier processeur (1) est assez rapide pour que son temps de traitement d'une multiplication 8 bits x 8 bits soit inférieur ou égal à 50 nanosecondes.

3. Compteur d'électricité selon la revendication 1 ou 2, **caractérisé en ce que** le deuxième processeur (2) est un processeur relativement lent, adapté à un traitement en masse de données, dont le temps de traitement d'une multiplication 8 bits x 8 bits est de l'ordre de 5 microsecondes.

4. Compteur d'électricité selon l'une des revendications 1 à 3, **caractérisé en ce qu'**il existe par courant mesuré ($i_j$) un élément à effet Hall (16) disposé dans un entrefer (14) d'un circuit magnétique (15) et alimenté par une tension constante (V) pour mesurer le courant concerné ($i_j$) au moyen d'un flux magnétique (Φ) proportionnel généré par ce dernier dans le circuit magnétique (15).

5. Compteur d'électricité selon l'une des revendications 1 à 3, **caractérisé en ce qu'**il existe par courant mesuré ($i_j$) un transformateur de courant pour mesurer le courant concerné ($i_j$).

6. Compteur d'électricité selon l'une des revendications 1 à 3, **caractérisé en ce qu'**il existe par courant mesuré ($i_j$) une bobine de Rogowski avec intégrateur monté en aval pour mesurer le courant concerné ($i_j$).

7. Compteur d'électricité selon l'une des revendications 1 à 6, **caractérisé en ce que** les convertisseurs analogique/numérique (3, 4) sont composés chacun d'un modulateur sigma-delta (11) et d'un filtre à décimation (12) monté en aval et qu'entre ces deux derniers est intercalé un registre à décalage (13) à commande numérique pour la compensation de décalages temporels qui sont générés lors de la détermination des courants ($i_j$).

8. Compteur d'électricité selon l'une des revendications 1 à 7, **caractérisé en ce qu'**une ou plusieurs des grandeurs physiques électriques à mesurer sont une ou plusieurs sortes d'énergie électrique et/ou de puissance électrique.

**9.** Compteur d'électricité selon l'une des revendications 1 à 8, **caractérisé en ce qu'**une ou plusieurs des grandeurs physiques électriques à mesurer sont un ou plusieurs angles de phase qui existent chaque fois entre une des tensions ($v_j$) et le courant associé ($i_j$).

**10.** Compteur d'électricité selon l'une des revendications 1 à 9, **caractérisé en ce qu'**une ou plusieurs des grandeurs physiques électriques à mesurer sont un ou plusieurs angles de phase qui existent chaque fois entre deux des tensions ($v_j$) ou deux des courants ($i_j$).

**11.** Compteur d'électricité selon l'une des revendications 1 à 10, **caractérisé en ce qu'**une ou plusieurs des grandeurs physiques électriques à mesurer sont des facteurs de puissance ($\lambda$).

**12.** Compteur d'électricité selon l'une des revendications 1 à 11, **caractérisé en ce qu'**une ou plusieurs des grandeurs physiques électriques à mesurer sont des fréquences des tensions ($v_j$) et/ou des courants ($i_j$).

**13.** Compteur d'électricité selon l'une des revendications 1 à 12, **caractérisé en ce que** dans des compteurs d'électricité polyphasés, une ou plusieurs des grandeurs physiques électriques à mesurer sont un courant de fil neutre et/ou une tension de fil neutre.

**14.** Compteur d'électricité selon l'une des revendications 1 à 13, **caractérisé en ce que** les valeurs d'une ou plusieurs des grandeurs physiques électriques à mesurer sont des valeurs efficaces des tensions ($v_j$) et/ou des courants ($i_j$).

**15.** Compteur d'électricité selon l'une des revendications 1 à 14, **caractérisé en ce que** les grandeurs auxiliaires sont des valeurs accumulées

$$\sum_{n=1}^{N}(V_{j,n} \cdot I_{j,n}) \text{ et/ou } \sum_{n=1}^{N}(V_{j,n}^2) \text{ et/ou}$$

$$\sum_{n=1}^{N}(I_{j,n}^2) \text{ , avec n = 1 à N, } V_{j,n} \text{ et } I_{j,n} \text{ étant respec-}$$

tivement les valeurs numériques des échantillons des tensions ($v_j$) et des courants ($i_j$) et N étant un nombre entier qui désigne un nombre d'échantillons qui sont mesurés par temps d'accumulation choisi.

**16.** Compteur d'électricité selon l'une des revendications 1 à 15, **caractérisé en ce que** les compteurs d'électricité sont des compteurs d'électricité triphasés et les grandeurs auxiliaires des valeurs accumulées $\sum_{n=1}^{N}(\sum_{j=1}^{3} I_{j,n})^2$ , avec n = 1 à N et j = 1 à 3,

$I_{j,n}$ étant les valeurs numériques des échantillons des courants ($i_j$) et N étant un nombre entier qui désigne un nombre d'échantillons qui sont mesurés par temps d'accumulation choisi.

## Fig.1

## Fig.2

$$V_{j,n}, I_{j,n}$$

$$V^*_{j,n}, I^*_{j,n}$$

## Fig.3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4884021 A
- US 5212441 A
- US 5298854 A
- US 5298856 A
- US 5298859 A
- US 4672555 A
- US 4794369 A
- US 5122735 A

- WO 9317345 A
- WO 9317390 A
- EP 742442 A
- EP 742443 A
- EP 742444 A
- US 5298857 A
- US 4810989 A